# EUROPEAN PATENT APPLICATION

(11) **EP 4 810 977 A1**
(43) Date of publication of application: **23.09.2026**
(21) Application number: 26163065.1
(22) Date of filing: 06.03.2026
(51) Int. Cl.: G01R 33/00, G01D 5/14, G01R 33/07, G01R 33/09

(54) **WAFER-LEVEL INTEGRATED MAGNETS FOR BACK BIAS APPLICATIONS**

(30) Priority: 12.03.2025 US 202519077496
(71) Applicant: Allegro MicroSystems, LLC, Manchester, NH 03103 (US)
(72) Inventor: LASSALLE-BALIER, Rémy, 91440 Bures-sur-Yvette (FR); LATHAM, Alexander, Harvard, 01451 (US); VUILLERMET, Yannick, 73290 La Motte Servolex (FR)
(74) Representative: South, Nicholas Geoffrey

(57) **Abstract**

A sensor including: a substrate having a cavity formed in a first main surface of the substrate; a first mesa that is formed in the cavity; a second mesa that is formed in the cavity a first magnet that is formed in the cavity, the first magnet being arranged to at least partially fill the cavity, the first magnet being arranged to surround the first mesa and the second mesa.

## Description

### BACKGROUND

As is known, sensors are used to perform various functions in a variety of applications. Some sensors include one or more electromagnetic flux sensing elements, such as a Hall effect element, a magnetoresistive element, or a receiving coil to sense an electromagnetic flux associated with proximity or motion of a target object. Sensor integrated circuits are widely used in automobile control systems and other safety-critical applications. There are a variety of specifications that set forth requirements related to permissible sensor quality levels, failure rates, and overall functional safety.

### SUMMARY

According to aspects of the disclosure, a sensor is provided, comprising: a substrate having a cavity formed in a first main surface of the substrate; a first mesa that is formed in the cavity; a second mesa that is formed in the cavity a first magnet that is formed in the cavity, the first magnet being arranged to at least partially fill the cavity, the first magnet being arranged to surround the first mesa and the second mesa.

According to aspects of the disclosure, a sensor comprising: a substrate having a cavity formed in a first main surface of the substrate; a first magnet that is formed in the cavity, the first magnet being arranged to at least partially fill the cavity; a first sensing bridge that is formed on a second main surface of the substrate, the second main surface being opposite to the first main surface, the first sensing bridge being arranged sense a magnetic field of the first magnet as the magnetic field is modulated by a rotating target and generate a sensing signal in response to the magnetic field.

According to aspects of the disclosure, a sensor comprising: a substrate having a cavity formed in a first main surface of the substrate and a mesa that extends from a bottom of the cavity; a first magnet that is formed in the cavity, the first magnet being arranged to surround the mesa, the first magnet being ring-shaped; one or more Hall elements that are formed on a second main surface of the substrate, the second main surface being opposite to the first main surface, the one or more Hall elements being arranged sense a magnetic field of the first magnet as the magnetic field is modulated by a rotating target and generate a sensing signal in response to the magnetic field.

According to aspects of the disclosure, an article of manufacture, comprising: a substrate having a cavity formed in a first main surface of the substrate; a first mesa that is formed in the cavity; a second magnet that is formed in the cavity, the second magnet being arranged to at least partially fill the cavity, the second magnet being arranged to surround the first mesa.

### BRIEF SUMMARY OF THE DRAWINGS

FIG. 1 is a diagram of an example of a sensor, according to aspects of the disclosure;
FIG. 2 is a diagram of an example of bridge circuits that are part of the sensor of FIG. 1;
FIG. 3A is a perspective top-down view of a sensor, according to aspects of the disclosure;
FIG. 3B is a cross-sectional side view of the sensor of FIG. 3A, according to aspects of the disclosure;
FIG. 3C is a planar bottom-up view of the sensor of FIG. 3A, according to aspects of the disclosure;
FIG. 3D is a planar top-down view of the sensor of FIG. 3A, according to aspects of the disclosure;
FIG. 3E is a cross-sectional side view of the substrate of the sensor of FIG. 3A after it has been etched out to accommodate a built-in magnet, according to aspects of the disclosure;
FIG. 3F is a cross-sectional side view of the substrate of the sensor of FIG. 3A after it has been etched out to accommodate a built-in magnet, according to aspects of the disclosure;
FIG. 3G is a partial planar top-down view of the sensor of FIG. 3A, according to aspects of the disclosure;
FIG. 3H is a partial planar top-down view of the sensor of FIG. 3A, according to aspects of the disclosure;
FIG. 4A shows a set of graphs illustrating aspects of the operation of the sensor of FIG. 3A, according to aspects of the disclosure;
FIG. 4B shows a set of graphs illustrating aspects of the operation of the sensor of FIG. 3A, according to aspects of the disclosure;
FIG. 4C shows a graph illustrating aspects of the operation of the sensor of FIG. 3A, according to aspects of the disclosure;
FIG. 4D shows a set of graphs illustrating aspects of the operation of the sensor of FIG. 3A, according to aspects of the disclosure;
FIG. 5A is a perspective top-down view of a sensor, according to aspects of the disclosure;
FIG. 5B is a cross-sectional side view of the sensor of FIG. 3A, according to aspects of the disclosure;
FIG. 5C is a perspective top-down view of a sensor, according to aspects of the disclosure;
FIG. 5D is a cross-sectional side view of the sensor of FIG. 3A, according to aspects of the disclosure;
FIG. 6A shows a set of graphs illustrating aspects of the operation of the sensor of FIG. 5A, according to aspects of the disclosure;
FIG. 6B shows a set of graphs illustrating aspects of the operation of the sensor of FIG. 5A, according to aspects of the disclosure;
FIG. 6C shows a graph illustrating aspects of the operation of the sensor of FIG. 5A, according to aspects of the disclosure;
FIG. 6D shows a set of graphs illustrating aspects of the operation of the sensor of FIG. 5A, according to aspects of the disclosure;
FIG. 7A is a perspective top-down view of a sensor, according to aspects of the disclosure;
FIG. 7B is a cross-sectional side view of the sensor of FIG. 7A, according to aspects of the disclosure;
FIG. 7C is a planar bottom-up view of the sensor of FIG. 7A, according to aspects of the disclosure;
FIG. 7D is a planar top-down view of the sensor of FIG. 7A, according to aspects of the disclosure;
FIG. 8A shows a graph illustrating aspects of the operation of the sensor of FIG. 7A, according to aspects of the disclosure; and
FIG. 8B shows a graph illustrating aspects of the operation of the sensor of FIG. 7A, according to aspects of the disclosure.

### DETAILED DESCRIPTION

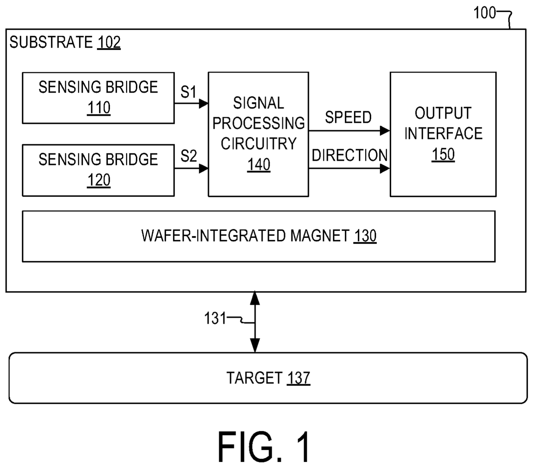

FIG. 1 is a diagram of an example of a back-bias sensor 100, according to aspects of the disclosure. Sensor 100 includes a magnet that is integrated into the sensor's wafer. Sensor 100 may be configured to detect speed, position, acceleration, and/or any other suitable characteristic of the movement of a target 137. According to the present example, target 137 is a rotating target, however, alternative implementations are possible in which target 137 moves linearly. According to the present example, target 137 is a metal gear. However, the present disclosure is not limited to any specific implementation of target 137.

As noted above, sensor 100 may include an integrated magnet 130. In operation, sensor 100 may be positioned in close proximity to target 137. As target 137 rotates, target 137 may alter the magnetic field produced by magnet 130, by either concentrating or diverting the lines of magnetic flux. The changes to magnetic flux are sensed by one or more sensing bridges that are part of the sensor and used to determine the speed, position, acceleration and/or other suitable characteristic of movement of target 137.

According to the present example, sensor 100 includes a substrate 102. The substrate 102 may include a silicon substrate and/or any other suitable type of substrate. Formed on the substrate 102 may be a sensing bridge 110, a sensing bridge 120, a signal processing circuitry 140, and an output interface 150. According to the present example, each sensing bridge 110 and 120 is a full-bridge circuit. However, alternative implementations are possible in which at least one of sensing bridges 110 and 120 is a half-bridge circuit. Furthermore, in some implementations, at least one of sensing bridges 110 and 120 may be omitted.

Signal processing circuitry 140 may include any suitable type of digital or analog electronic circuitry that is conventionally found in magnetic field sensors. By way of example, processing circuitry 140 may include one or more of: (i) at least one digital-to-analog converter (DAC), (ii) at least one analog-to-digital converter (ADC), (iii) at least one processor, such as a general-purpose processor, an application-specific processor, or a digital signal processor, (iv) a memory, (v) at least one analog filter, (vi) at least one digital filter, (vii) at least one amplifier, and so forth. The output interface 150 may include any suitable type of circuitry that is used for generating an output signal. By way of example, the output interface 150 may include one or more of an output signal driver, an inter-integrated circuit (I2C) interface, a controller area network bus (CANBUS), a pulse-width modulation (PWM) interface, and/or any other suitable type of interface.

The sensor 100 may be separated from target 137 by an air gap 131. In operation, magnet 130 may generate a magnetic field that is subsequently modulated by target 137, as target 137 rotates (or otherwise moves). Sensing bridge 110 may sense the modulated magnetic field and generate a signal S1 in response to the magnetic field. Sensing bridge 120 may also sense the modulated magnetic field and generate a signal S2 in response to the magnetic field. Signal processing circuitry 140 may process the signals S1 and S2 to generate respective speed and direction signals (or at least one of them). As the name suggests, those signals may be indicative of the speed and direction of target 137, and they may be generated in the manner discussed further below with respect to equations 1-6. Output interface may 150 may be configured to generate one or more output signals that encode the speed and direction signals and provide the generated output signals OUT to external circuitry that coupled to sensor 100.

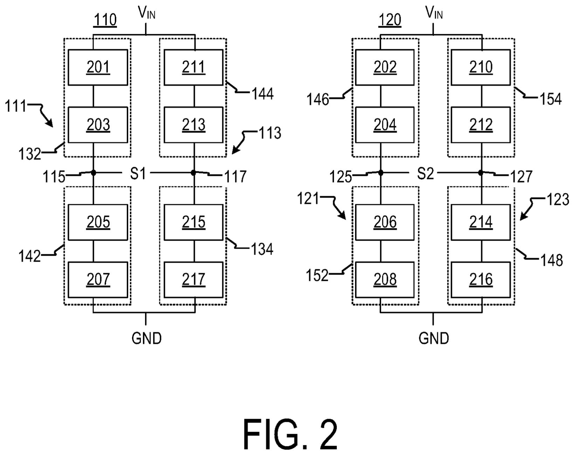

FIG. 2 shows a diagram of sensing bridges 110 and 120, according to aspects of the disclosure. As illustrated, sensing bridge 110 may include sensing portions 132, 134, 142, and 144. Sensing portions 132 and 142 may be coupled in series to each other to form a leg 111. Sensing portions 144 and 134 may be coupled series to each other to form a leg 113. Legs 111 and 113 may be coupled in parallel between a voltage source and ground. The signal S1 may be output on nodes 115 and 117, as shown. Sensing bridge 120 may include sensing portions 146, 148, 152, and 154. Sensing portions 146 and 152 may be coupled in series to form a leg 121. Sensing portions 154 and 148 may be coupled in series to form a leg 123. Legs 121 and 123 may be coupled in parallel between a voltage source and ground. The signal S2 may be output on nodes 125 and 127, as shown.

Sensing portion 132 may include sensing elements 201 and 203; sensing portion 142 may include sensing elements 205 and 207; sensing portion 144 may include sensing elements 211 and 213; and sensing portion 134 may include sensing elements 215 and 217. Although, in the present example, each of sensing portions 132, 142, 144, and 134 includes two sensing elements, it will be understood that any of sensing portions 132, 142, 144, and 134 may include only one sensing element or more than two sensing elements. In the present example, each of sensing elements 201, 203, 205, 207, 211, 213, 215, and 217 (hereinafter "sensing elements 201-217") is a tunneling magnetoresistance (TMR) vortex element. However, alternative implementations are possible in which any of sensing elements 201-217 is a different type of magnetic field sensing element, such as a giant magnetoresistance (GMR) element or a Hall plate. Stated succinctly, the present disclosure is not limited to any specific implementation of sensing elements 201-217.

Sensing portion 146 may include sensing elements 202 and 204; sensing portion 152 may include sensing elements 206 and 208; sensing portion 154 may include sensing elements 210 and 212; and sensing portion 148 may include sensing elements 214 and 216. Although, in the present example, each of sensing portions 146, 152, 154, and 148 includes two sensing elements, it will be understood that any of sensing portions 146, 152, 154, and 148 may include only one sensing element or more than two sensing elements. In the present example, each of sensing elements 202, 204, 206, 208, 210, 212, 214, and 216 (hereinafter sensing elements "202-216") is a TMR vortex element. However, alternative implementations are possible in which any of sensing elements 202-216 is a different type of magnetic field sensing element, such as a giant magnetoresistance (GMR) element or a Hall plate. Stated succinctly, the present disclosure is not limited to any specific implementation of sensing elements 202-216.

Under the nomenclature of the present disclosure, two sensing portions (or elements) of a sensing bridge are considered diagonally opposed in the topology of the sensing bridge when the two portions (or elements) belong in different legs of the bridge, such that one of the sensing portions (or elements) is situated between the voltage source of the bridge and a first output node of the bridge, and the other sensing portion (or element) is disposed between the ground source (or negative) terminal of the sensing bridge and another output node of the sensing bridge. In the example of FIG. 2, sensing portions 132 and 134 are diagonally opposed; sensing portions 142 and 144 are diagonally opposed; sensing portions 146 and 148 are diagonally opposed; and sensing portions 152 and 154 are diagonally opposed.

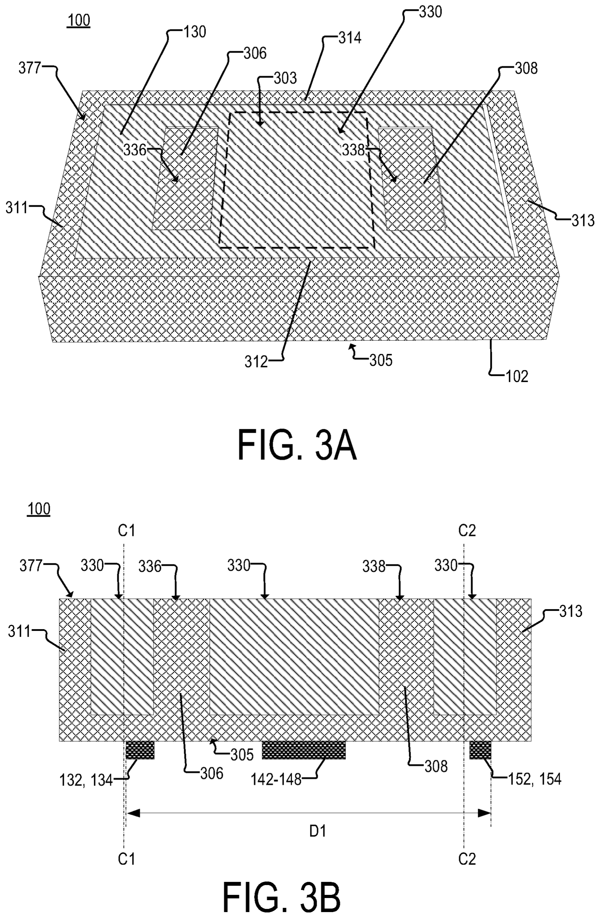

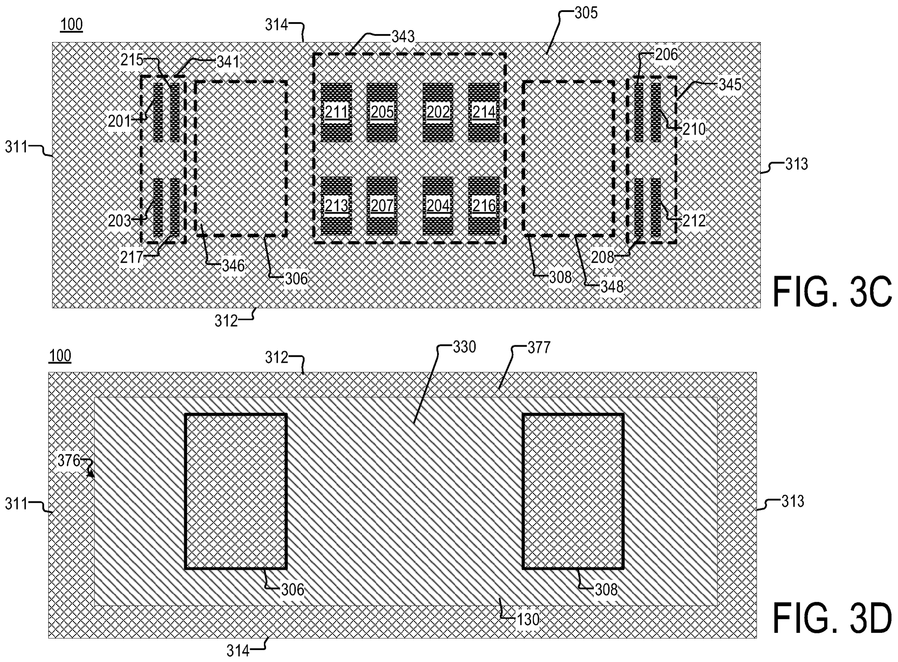

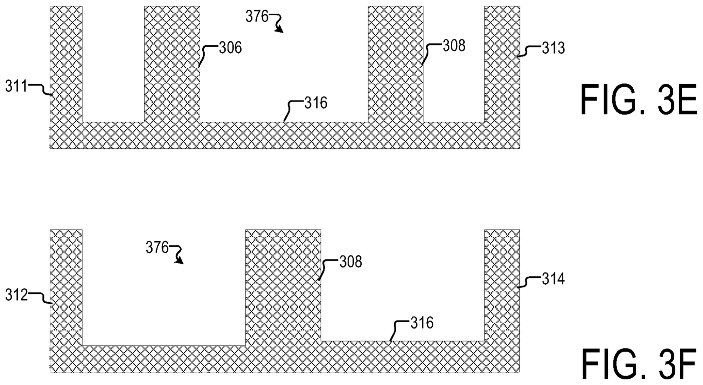

FIGS. 3A-H show an example of the sensor 100, according to one particular implementation. In the example, of FIGS. 3A-D, the substrate includes a top surface 377 and a bottom surface 305. A cavity 376 (shown in FIGS. 3E-F) is etched in the top surface 377 and subsequently filled with magnetic powder, after which the magnetic powder is solidified using atomic layer deposition to form the magnet 130. As illustrated, mesas 306 and 308 are formed inside the cavity 376. The mesas 306 and 308 are surrounded by the magnet 130. The magnet 130 is surrounded by edges 311, 312, 313, and 314 of the substrate 102. Sensing portions 132 and 134 are situated underneath the portion of magnet 130 that is disposed between mesa 306 and edge 311; sensing portions 142, 144, 146, and 148 (hereinafter "sensing portions 142-148") are disposed underneath the portion of magnet 130 that is situated between mesas 308 and 306; and sensing portions 152 and 154 are disposed underneath the portion of magnet 130 that is situated between mesa 308 and edge 313.

In the example of FIG. 3A, mesa 306 has a top surface 336, mesa 308 has a top surface 338, and the magnet 130 has a top surface 330. The top surface 377 of substrate 102 and the top surfaces 336, 338, and 330 are flush with each other, and together form a top surface 303 of sensor 100. However, alternative implementations are possible in which at least one of the top surfaces 377, 336, 338, and 330 is recessed relative to another one of the top surfaces 377, 336, 338, and 330.

FIGS. 3E-F show in further detail the cavity 376 that is etched in the substrate 102, and inside which the magnet 130 is formed. FIGS. 3E-F illustrate that the cavity is defined by edges 311, 312, 313, and 314. As illustrated, the edges 311, 312, 313, and 314 and mesas 306 and 308 may be protrusions that remain after portions of the substrate 102 are etched out to form the cavity 376. In the example of FIGS. 3E-F, mesas 308 and 306 extend from the bottom 316 of cavity 376. Although, in the example of FIGS. 3A-H, two mesas are present in the cavity 376, alternative implementations are possible in which no mesas are formed in the cavity 376 or a different number of mesas is formed (*e.g.,* 1 mesa, 3 mesas, 4 mesas, 5 mesas, 6 mesas, *etc.*)*.* Although, in the example of FIGS. 3E-F, the cavity 376 has a rectangular footprint, in alternative implementations the footprint may have different a shape, such as a circular shape or an oval shape. In some implementations, the magnet 130 may be arranged to at least partially fill the cavity 376. For example, the top surface 330 of magnet 130 may be flush with the top surface 377 of substrate 102 (which is also the top surface of edges 130) or it may rest below top surface 377 (and/or the respective top surfaces of mesas 306 and 308).

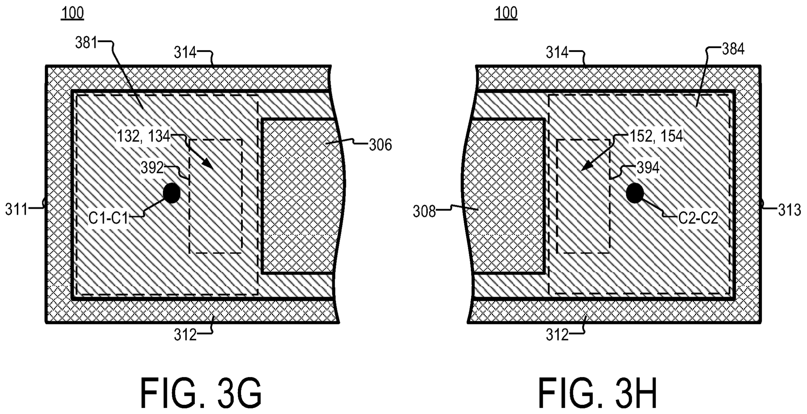

FIG. 3G is a partial view of sensor 100, which illustrates in further detail the positioning of sensing portions 132 and 134 relative to a portion 381 of magnet 130. Portion 381 is situated between edge 311 and mesa 306, and extends all the way to edges 311, 312, 314, and mesa 306. As illustrated, portion 381 has a central longitudinal axis C1-C1 and each of the sensing elements that make up sensing portions 132 and 134 may be situated underneath a region 392 of portion 381. FIG. 3H is a partial view of sensor 100, which illustrates in further detail the positioning of sensing portions 152 and 154 relative to a portion 384. Portion 384 of magnet 130 is situated between edge 313 and mesa 308 and extends all the way to edges 312, 313, 314, and mesa 308. As illustrated, portion 384 has a central longitudinal axis C2-C2 and each of the sensing elements that make up sensing portions 152 and 154 may be situated between mesa 308 and edge 314, underneath a region 394 of portion 384.

FIG. 3C is a planar top-down view of sensor 100, which illustrates one possible placement of sensing elements 201-217 and sensing elements 202-216 on the bottom surface 305 of the substrate 102. As illustrated, the bottom surface 305 may include portions 341, 346, 343, 348, and 345. Portion 346 is disposed directly underneath mesa 306, portion 348 is disposed directly underneath mesa 308, portion 341 is disposed directly underneath region 392 of magnet 130, portion 343 is disposed directly underneath the part of magnet 130 that is disposed between mesa 306 and mesa 308, and portion 345 is disposed directly underneath region 394 of magnet 130.

In the example of FIG. 3C, sensing elements 201, 203, 215, and 217 may be formed in portion 341, such that sensing elements 215 and 217 are disposed between sensing elements 201 and 203 and portion 346. Sensing elements 206, 208, 210, and 212 may be formed in portion 345, such that sensing elements 206 and 208 are disposed between sensing elements 210 and 212 and portion 348. And sensing elements 211, 213, 205, 207, 202, 204, 214, and 216 may be disposed in portion 343. As illustrated, sensing elements 202, 204, 214, and 216 may be disposed adjacent to portion 348, such that sensing elements 214 and 216 are disposed between sensing elements 202 and 204 and portion 348. Similarly, sensing elements 211, 213, 205, and 207 may be disposed adjacent to portion 346, such that sensing elements 211 and 213 are disposed between sensing elements 205 and 207 and potion 346.

FIGS. 3C and 3G-H are provided to illustrate that in one implementation, sensing elements 201, 203, 215, and 217 may be disposed off-center from the portion of magnet 130 that is situated between mesa 306 and edge 311. FIGS. 3C and 3G-H are further provided to illustrate that one implementation, sensing elements 206, 208, 210, and 212 are disposed off-center from the portion of magnet 130 that is situated between mesa 308 and edge 313. According to the present disclosure, it has been determined that placing the sensing elements off-center in this manner is advantageous because it helps reduce the offset in the output of the sensing elements. According to the present disclosure, the magnet shape illustrated in FIGS. 3A-H has been determined to be advantageous with respect to keeping low the offset in the speed and direction signals (shown in FIG. 1).

In one example, the output of bridges 110 and 120 (shown in FIG. 1) may be used to calculate the speed and direction of target 137 (shown in FIG. 2). The speed and direction of target 137 may be indicated by the speed and direction signals, which are discussed above with respect to FIG. 1. The speed signal may be calculated in accordance with equations 3 and 4 below, and the direction signal may be calculated in accordance with equations 5 and 6 below: $S 1 = {S}_{115} - {S}_{117}$ $S 2 = {S}_{125} - {S}_{127}$ $Speed = S 1 - S 2$ $Speed = 2 ∗ {S}_{117} - {S}_{115} - {S}_{127}$$Direction = S 1 + S 2$ $Direction = {S}_{115} - {S}_{127}$ where S₁₁₅ is the signal output by sensing bridge 110 on node 115 (shown in FIG. 2), S₁₁₇ is the signal output by sensing bridge 110 on node 117 (shown in FIG. 2), S₁₂₅ is the signal output by sensing bridge 120 on node 125 (shown in FIG. 2), and S₁₂₇ is the signal output by sensing bridge 120 on node 127 (shown in FIG. 2).

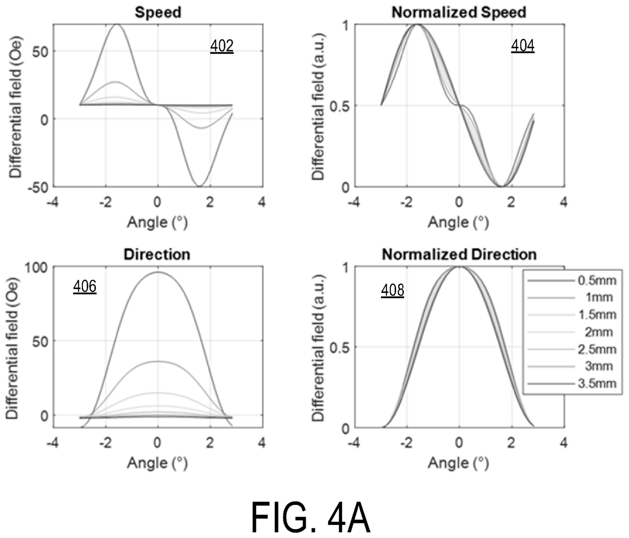

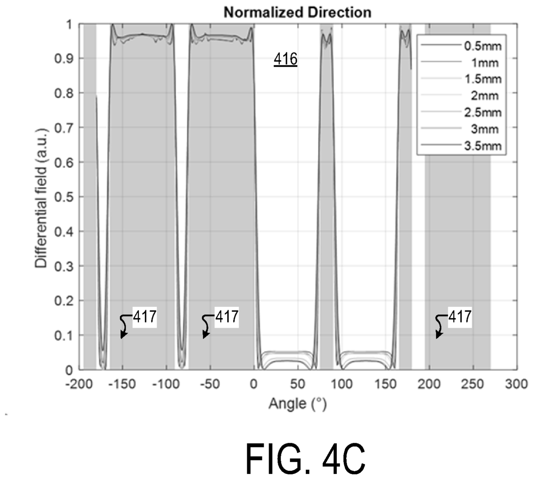

FIGS. 4A-D show the results from different simulations of the design of sensor 100, which is shown in FIGS. 3A-H. FIGS. 4A-B shows the results of simulating the operation of sensor 100 when target 137 is a gear with 60 teeth. FIGS. 4C-D show the results of simulating the operation of sensor 100 when target 137 is a 4x cam target.

FIG. 4A shows plots 402, 404, 406, and 408 the speed and direction signals that are produced by sensor 100 for different values of air gap 131. The X-axis of each plot represents the position of the target 137 (measured in degrees), and the Y-axis of each plot represents the value of the speed signal (measured in Oe). Plot 402 includes a plurality of curves, wherein each of the curves represents the raw speed signal that is simulated for a different one of a plurality of values of air gap 131. Plot 404 includes a plurality of curves, wherein each of the curves in is generated by normalizing a different respective one of the curves shown in plot 402. In other words, plot 404 shows the normalized speed signal for different values of air gap 131. Plot 406 includes a plurality of curves, wherein each of the curves represents the raw direction signal that is simulated for a different one of the plurality of values for air gap 131. Plot 408 includes a plurality of curves, wherein each of the curves in plot 408 is generated by normalizing a different respective one of the curves shown in plot 406. In other words, plot 408 shows the normalized direction signal for different values of air gap 131.

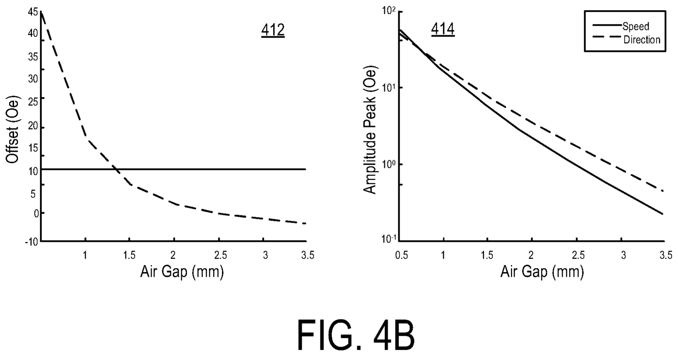

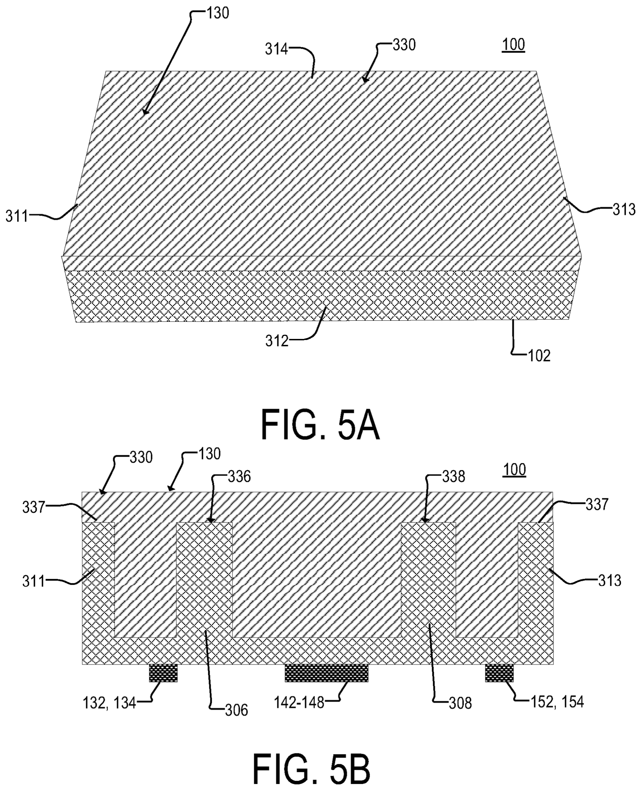

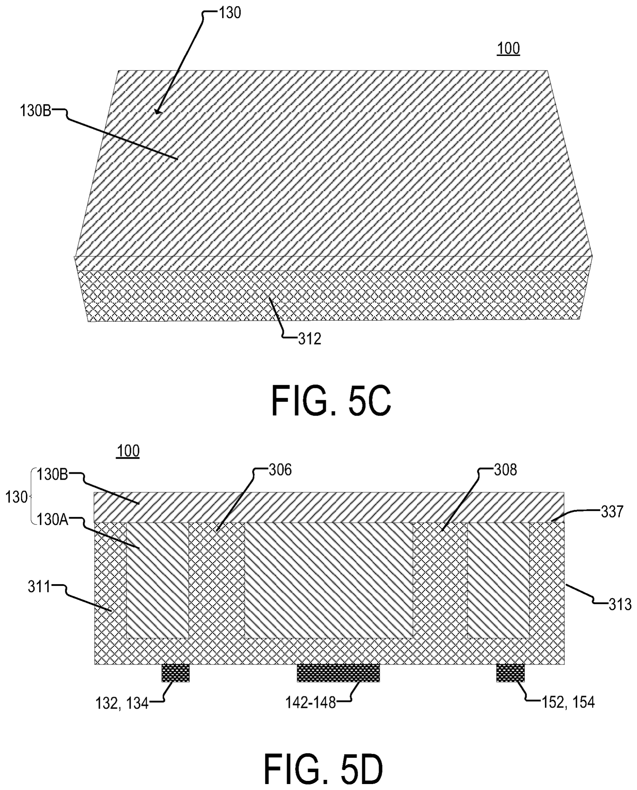

FIG. 4B shows plots 412 and 414. Plot 412 includes curves that represent the offset of the speed and direction signals for different values of air gap 131. The X-axis of plot 412 represents the value of air gap 131 (measured in mm) and the Y-axis of plot 412 represents offset (measured in Oe). Plot 414 shows the amplitude of the speed and direction signals for different values of the air gap 131. The X-axis of plot 414 represents the value of air gap 131 (measured in mm) and the Y-axis of plot 412 represents amplitude (measured in Oe). FIG. 4B illustrates that increasing the size of the air gap to around 2 mm may drastically reduce, or ideally eliminate, any offset in the direction signal, while generally reducing its amplitude. It is notable that the offset of the speed channel is a simulation artifact. Because of the symmetry of the system, the offset of the speed channel is actually zero. The offset of the direction channel is tunable by increasing the size of magnet 130 (*e.g.,* in the manner discussed with respect to FIGS. 5A-B) and/or increasing the size of mesas 306 and 308. Also, because the magnet 130 is much closer to the sensing bridges 110 and 120 (due to the magnet 130 being integrated into the substrate 102), it is possible to widen the distance D1 (shown in FIG. 3B) between sensing portions 132 and 134 and sensing portions 152 and 154, which may bring more signal and reduce the inflection/reversal of the derivative of the speed channel in the center of the teeth of target 137.

FIG. 4C shows a plot 416 of the normalized direction signal for different values of the air gap 131, when target 137 is a 4x cam target. The X-axis of plot 416 represents the angular position of the target, and the Y-axis represents a normalized differential field (measured in a.u.). Regions 417 represent the teeth of the 4x cam target. The curves shown in FIG. 4C represent a normalized direction signal. Each of the curves corresponds to a different value of air gap 131. The curves cross at about 80 to 85% level (as with existing magnet designs) but present a drastic improvement as the top part of the curve stays between 95% and 100% (in previous designs this could go down to 90% forcing to lower the level of the trigger) allowing for a safer trigger at 85%. This provides better over-air-gap accuracy. Also, because the design of sensor 100 (shown in FIGS. 1A-3D) may work with vertical Hall or magnetoresistance (MR) elements (*e.g*., TMR or GMR vortices), it can work below 1.5mm air gap, unlike GMR back bias cam products that are available on the market. Because the alignment of the integrated magnet (*i.e.,* magnet 130) is within a few microns (vs 150µm for the nonintegrated magnets that are used in existing sensor products) it is much easier to have the level for true power on system at 0mV bridge output. This in turn provides a TPOS level with virtually no dependance over temperature.

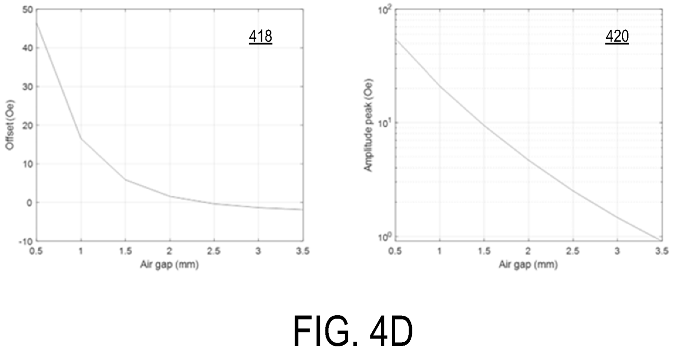

FIG. 4D shows plots 418 and 420. Plot 418 includes a curve that represents the offset of the direction signal for different values of air gap 131. The X-axis of plot 418 represents the value of air gap 131 (measured in mm) and the Y-axis of plot 412 represents offset (measured in Oe). Plot 420 shows the amplitude of the direction signal for different values of the air gap 131. The X-axis of plot 414 represents the value of air gap 131 (measured in mm) and the Y-axis of plot 412 represents amplitude (measured in Oe). FIG. 4D illustrates that increasing the size of the air gap to around 2 mm may drastically reduce, or ideally eliminate, any offset in the direction signal, while generally reducing the amplitude of the speed signal.

FIGS. 5A-B show an example of sensor 100, in accordance with another implementation. The implementation of FIGS. 5A-B is identical to the implementation shown in FIGS. 3A-D, but for the magnet 130 being arranged to overflow the edges 311, 312, 313, and 314 of the cavity 376. As a result of this arrangement, the top surface 330 covers the top surface 377 of edges 311, 312, 313, and 314, and the top surfaces 336 and 338 of mesas 306 and 308, respectively. In the example of FIGS. 5A-B, the top surface 330 of magnet 130 constitutes the entire top surface 303 of sensor 100. An advantage of the arrangement shown in FIGS. 5A-B is that results in a larger magnet, which is capable of producing a stronger field. Although, in the example of FIG. 5A, magnet 130 is arranged to cover the top surfaces of edges 311, 312, 313, 314, alternative implementations are possible in which magnet 130 does not overlap the top surface of at least one of edges 311, 312, 313, and 314.

In the example of FIGS. 5A-B, magnet 130 is integral. However, alternative implementations are possible in which magnet 130 is non-integral. As illustrated in FIGS. 5C-D, magnet 130 includes portions 130A and 130B. Portion 130A is identical to the entire magnet 130 of the example of FIGS. 3A-H, and portion 130B is a sheet of magnetic material that is adhered (*e.g.,* glued) to portion 130A. FIGS. 5C-D are provided to illustrate an example of an alternative approach to extending the size of magnet 130.

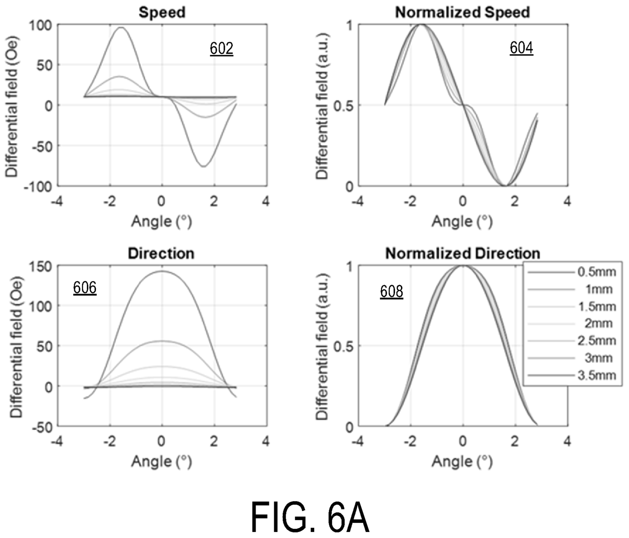

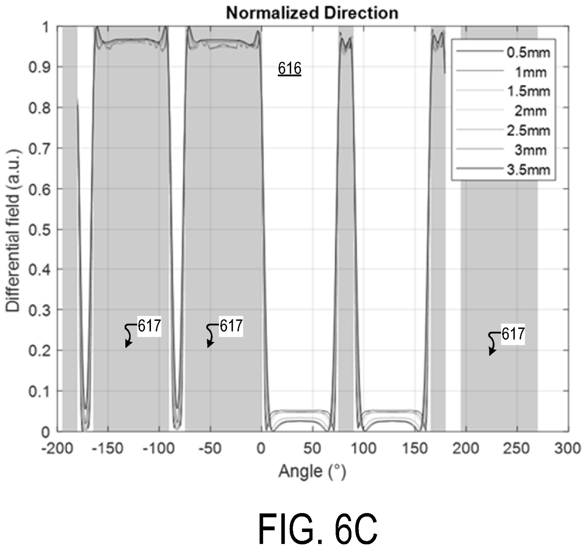

FIGS. 6A-D show the results from different simulations of the design of sensor 100, which is shown in FIGS. 5A-B. Specifically, the plots in FIGS. 6A-D should be compared to those in FIGS. 4A-D to understand how increasing the size of magnet 130 affects the performance of sensor 100. FIGS. 6A-B shows the results of simulating the operation of sensor 100, when target 137 is a gear with 60 teeth. FIGS. 6C-D show the results of simulating the operation of sensor 100 when target 137 is a 4x cam. The simulations of FIGS. 6A-D were performed by using the same target models as the simulations whose outcome is illustrated in FIGS. 4A-D.

FIG. 6A shows plots 602, 604, 606, and 608 of the speed and direction signals that would be generated by sensor 100 when target 137 is a gear with 60 teeth. The X-axis of each plot represents the position of the target 137 (measured in degrees), and the Y-axis of each plot represents the value of the speed signal (measured in Oe). Plot 602 includes a plurality of curves, wherein each of the curves represents the respective raw speed signal for a different one of a plurality of values for air gap 131. Plot 604 includes a plurality of curves, wherein each of the curves in plot 604 is generated by normalizing a different respective one of the curves shown in plot 602. In other words, plot 604 shows the normalized speed curves for different values of air gap 131. Plot 606 includes a plurality of curves, wherein each of the curves represents the raw direction signal for a respective one of the plurality of values for air gap 131. Plot 608 includes a plurality of curves, wherein each of the curves in plot 608 is generated by normalizing a different respective one of the curves shown in plot 606. In other words, plot 608 shows normalized direction curves for different values of air gap 131.

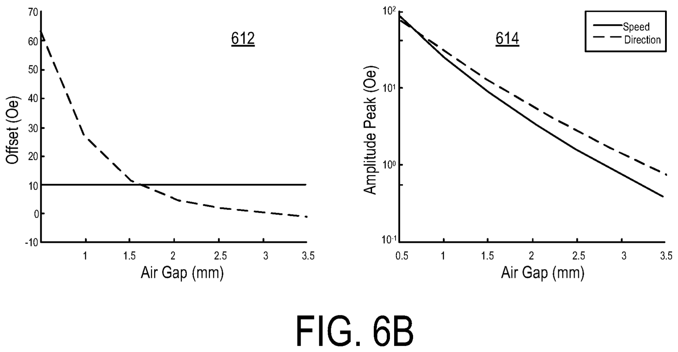

FIG. 6B shows plots 612 and 614. Plot 612 includes curves that represent the offset in the speed and direction signals for different values of air gap 131. The X-axis of plot 612 represents the value of air gap 131 (measured in mm) and the Y-axis of plot 612 represents offset (measured in Oe). Plot 614 shows the amplitude of the speed and direction signals for different values of the air gap. The X-axis of plot 614 represents the value of air gap 131 (measured in mm) and the Y-axis of plot 612 represents amplitude (measured in Oe). FIGS. 6A-B illustrate that increasing the size of magnet 130 (as shown in FIGS. 5A-B) does not affect the shape of the speed and direction signals. FIGS. 6A-B further illustrate that increasing the size of magnet 130 (as shown in FIGS. 5A-B) increases the gain of the speed and direction signals.

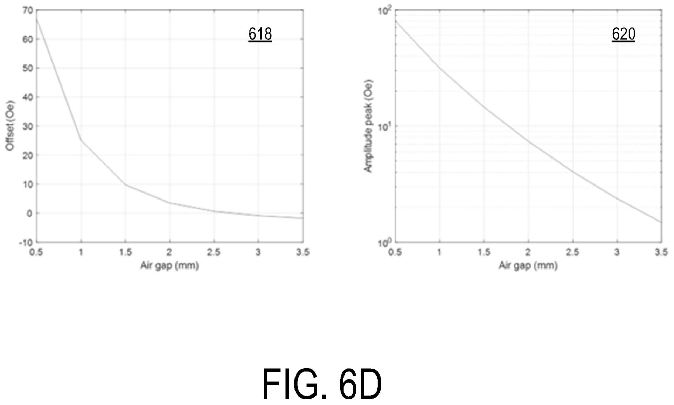

FIG. 6C shows a plot 616 of the direction signal, when target 137 is a 4x cam target, for different values of the air gap 131. The X-axis of plot 616 represents the angular position of the target, and the Y-axis represents a differential field (measured in a.u.). Regions 617 represent the teeth of the 4x cam target. The curves shown in FIG. 6C represent a normalized speed signal (as opposed to a raw one). FIG. 6D shows plots 618 and 620. Plot 618 includes curves that represent the offset in the direction signal for different values of air gap 131. The X-axis of plot 612 represents the value of air gap 131 (measured in mm) and the Y-axis of plot 612 represents offset (measured in Oe). Plot 620 shows the amplitude of the direction signal for different value of the air gap 131. The X-axis of plot 614 represents the value of air gap 131 (measured in mm) and the Y-axis of plot 612 represents the amplitude (measured in Oe) of the direction signal. In the example of FIGS. 6C-D, the signal shape is unaffected (in comparison to FIGS. 4C-D), the magnet shape (shown in FIGS. 3A-D) is tuned to keep the offset low and the amplitude is increased by about 60% at 3mm air gap by a 0.5mm thick range extender. The term "range extender" refers to additional volume that is added to the design of magnet 130 which is shown in FIGS. 5A-D, in comparison to the design of magnet 130 shown in FIGS. 3A-H.

In some implementations, the magnet portion 130B (shown in FIGS. 5C-D) can be diced along with the wafer. In some implementations, magnet 130 may be magnetized after packaging. In some respects, sensor 100 can be implemented with TMR vortices, as with existing GMR back bias current products, but at a lower manufacturing cost. In someimplementations, TMR vortices may use pillars having a diameter of 0.5 to 2µm and keeping the spacing between pillars equal to the pillar diameter. Otherwise, the pillars may occupy the same amount of on-die space as the GMRs in existing back-bias products.

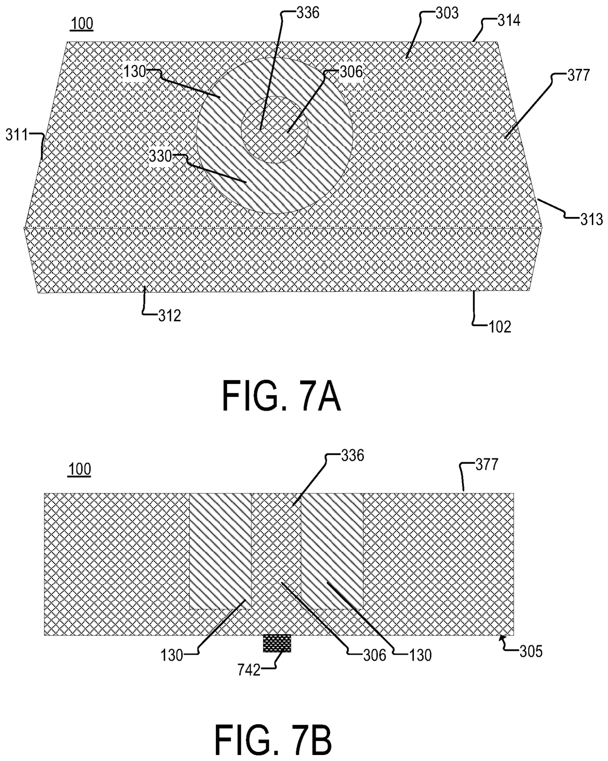

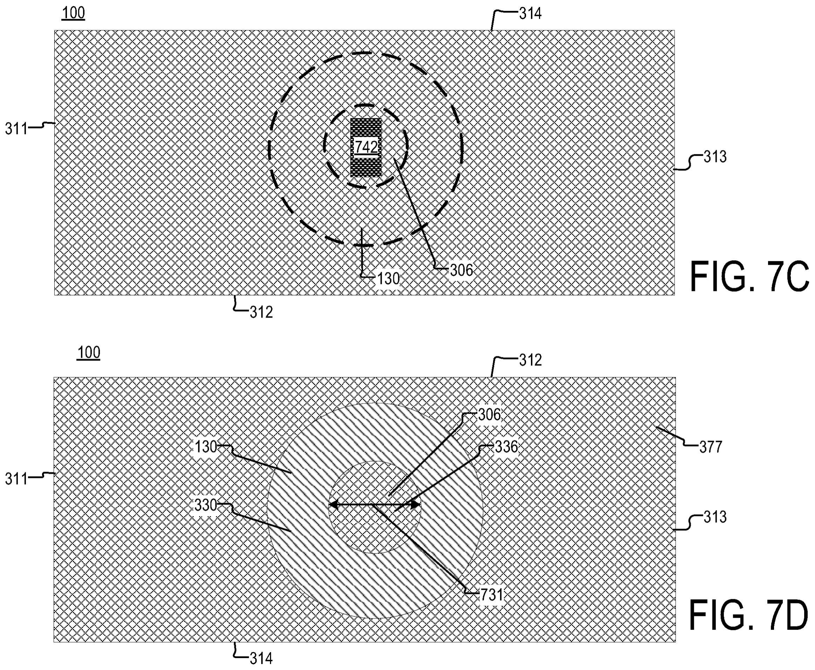

FIGS. 7A-D show an example of sensor 100, in accordance with yet another implementation. In the example of FIGS. 7A-D, mesa 308 is omitted, mesa 306 is positioned further towards the middle of the substrate 102, the magnet 130 is ring-shaped and formed around mesa 306, and sensor 100 is provided with one or more sensing elements 742. Specifically, in the example of FIGS. 7A-D, the magnet 130 is shaped as a cylinder with a bore extending along (and centered on) the axis of rotation of the cylinder. The magnet may have a hole diameter 731. As noted above, the magnet 130 may be formed by etching a ring-shaped cavity into the substrate 102, filling the cavity with magnetic powder, and solidifying the magnetic powder by using atomic layer deposition. In some implementations, magnet 130 may be manufactured by using a process that is the same or similar to the one described in U.S. Patent 9,221,217 entitled "Method for Producing a Three-Dimensional Structure and Three-Dimensional Structure," which is herein incorporated by reference in its entirety. In the present example, sensing elements 742 include a single Hall element. However, alternative implementations are possible in which Hall elements 742 includes a plurality of Hall elements. Additionally or alternatively, in some implementations, sensing elements 742 may include one or more TMR vortex elements, one or more GMR elements, and/or any other suitable type of magnetic field sensing element, The Hall elements, in this example, are planar Hall elements. However, alternative implementations are possible in which the Hall elements are vertical Hall elements. The Hall elements 742 may be disposed underneath mesa 306, as shown. Hall elements 742 are used to replace sensing elements 132, 134, 142-148, 152, and 154, and they perform the same function. Namely, Hall elements 742 may sense a magnetic field of the magnet 130 that is modulated by a rotating target and generate a sensing signal in response to the magnetic field. As noted above, sensor 100 may include electronic circuitry that is configured to generate, based at least in part on the sensing signal, an output signal that indicative of a speed or direction of the rotating target.

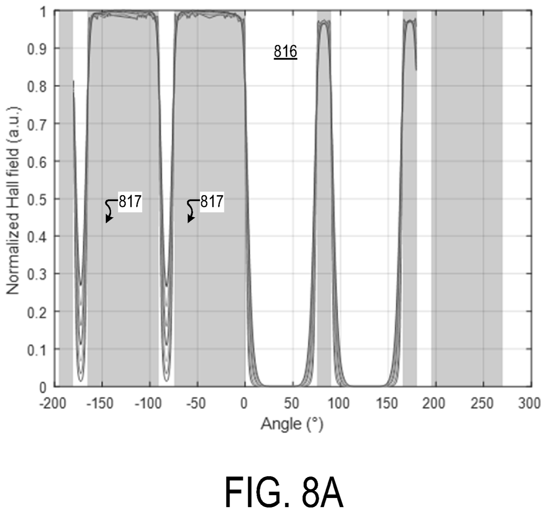

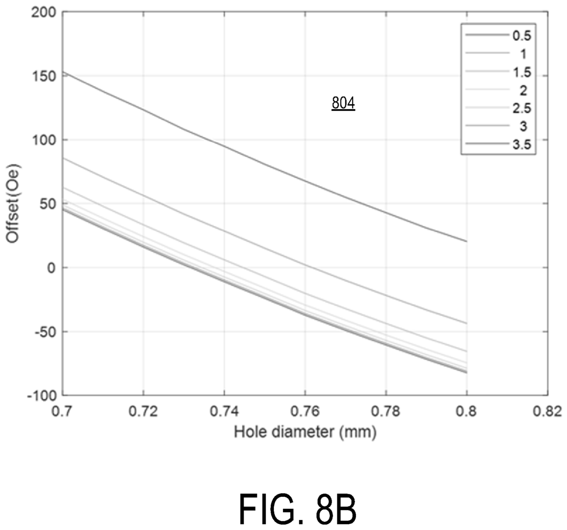

FIGS. 8A-B shows the results from different simulations of the design of sensor 100, which is shown in FIGS. 7A-B. FIG. 8A shows a plot 816 of the output of Hall element 742 (*e.g.,* a speed signal) for different values of the hole diameter 731. The X-axis of plot 816 represents the angular position of the target, and the Y-axis represents a normalized out-of-plane field (measured in a.u.). Regions 817 represent the teeth of the 4x cam target. FIG. 8B shows a plot 804, which shows a plurality of curves that represent the offset of the output of the Hall element 742 for different values of the hole diameter 731.

The concepts and ideas described herein may be implemented, at least in part, via a computer program product, (e.g., in a non-transitory machine-readable storage medium such as, for example, a non-transitory computer-readable medium), for execution by, or to control the operation of, data processing apparatus (e.g., a programmable processor, a computer, or multiple computers). Each such program may be implemented in a high-level procedural or object-oriented programming language to work with the rest of the computer-based system. However, the programs may be implemented in assembly, machine language, or Hardware Description Language. The language may be a compiled or an interpreted language, and it may be deployed in any form, including as a stand-alone program or as a module, component, subroutine, or another unit suitable for use in a computing environment. A computer program may be deployed to be executed on one computer or multiple computers at one site or distributed across multiple sites and interconnected by a communication network. A computer program may be stored on a non-transitory machine-readable medium that is readable by a general or special-purpose programmable computer for configuring and operating the computer when the non-transitory machine-readable medium is read by the computer to perform the processes described herein. For example, the processes described herein may also be implemented as a non-transitory machine-readable storage medium, configured with a computer program, where upon execution, instructions in the computer program cause the computer to operate in accordance with the processes. A non-transitory machine-readable medium may include but is not limited to a hard drive, compact disc, flash memory, non-volatile memory, or volatile memory. The term unit (*e.g.,* an addition unit, a multiplication unit, *etc.*)*,* as used throughout the disclosure may refer to hardware (*e.g*., an electronic circuit) that is configured to perform a function (*e.g.,* addition or multiplication, *etc.*)*,* software that is executed by at least one processor, and configured to perform the function, or a combination of hardware and software.

Also, for purposes of this description, the terms "couple," "coupling," "coupled," "connect," "connecting," or "connected" refer to any manner known in the art or later developed in which energy is allowed to be transferred between two or more elements, and the interposition of one or more additional elements is contemplated, although not required. Conversely, the terms "directly coupled," "directly connected," etc., imply the absence of such additional elements.

As used herein in reference to an element and a standard, the term "compatible" means that the element communicates with other elements in a manner wholly or partially specified by the standard, and would be recognized by other elements as sufficiently capable of communicating with the other elements in the manner specified by the standard. The compatible element does not need to operate internally in a manner specified by the standard.

Having described preferred embodiments, which serve to illustrate various concepts, structures and techniques, which are the subject of this patent, it will now become apparent that other embodiments incorporating these concepts, structures and techniques may be used. Accordingly, it is submitted that the scope of the patent should not be limited to the described embodiments but rather should be limited only by the spirit and scope of the following claims.

## Claims

1. A sensor, comprising:
a substrate having a cavity formed in a first main surface of the substrate;
a first mesa that is formed in the cavity;
a first magnet that is formed in the cavity, the first magnet being arranged to at least partially fill the cavity, the first magnet being arranged to surround the first mesa.

2. The sensor of claim 1, further comprising a second mesa that is formed in the cavity, wherein the first magnet is arranged to surround the second mesa.

3. The sensor of claim 1 or 2, wherein the first magnet has a rectangular footprint.

4. The sensor of claim 2, further comprising a sensing bridge that is formed on a second main surface of the substrate, the second main surface being opposite to the first main surface, the sensing bridge including a plurality of first magnetic field sensing elements and a plurality of second magnetic field sensing elements, the plurality of first magnetic field sensing elements being formed on a side of the first mesa and the second mesa, the plurality of second magnetic field sensing elements being formed between the first mesa and the second mesa.

5. The sensor of claim 4, wherein the plurality of first magnetic field sensing elements includes at least two first magnetic field sensing elements that are diagonally opposed to each other in a topology of the sensing bridge, and the plurality of second magnetic field sensing elements includes at least two second magnetic field sensing elements that are diagonally opposed to each other in the topology of the sensing bridge.

6. The sensor of claim 4, wherein the plurality of first magnetic field sensing elements are positioned off-center from a portion of the first magnet that is situated between the first mesa and a first edge of the cavity.

7. The sensor of claim 4, wherein the plurality of second magnetic field sensing elements are positioned in greater proximity to the first mesa than the second mesa.

8. The sensor of claim 4, wherein the sensing bridge is configured to sense a first magnetic field of the first magnet as the first magnetic field is modulated by a rotating target and generate a sensing signal in response to the first magnetic field, the sensor further comprising an electronic circuitry that is configured to generate, based on the sensing signal, an output signal that is indicative of a speed of the rotating target.

9. The sensor of claim 4, wherein at least one of the first magnetic field sensing elements and the second magnetic field sensing elements includes a tunneling magnetoresistance (TMR) vortex element.

10. The sensor of claim 2, further comprising:
a first sensing bridge that is formed on a second main surface of the substrate, the second main surface being opposite to the first main surface, the first sensing bridge including a plurality of first magnetic field sensing elements and a plurality of second magnetic field sensing elements, the plurality of first magnetic field sensing elements being formed on a first side of the first mesa and the second mesa, the plurality of second magnetic field sensing elements being formed between the first mesa and the second mesa; and
a second sensing bridge that is formed on a second main surface of the substrate, the second sensing bridge including a plurality of third magnetic field sensing elements and a plurality of fourth magnetic field sensing elements, the plurality of third magnetic field sensing elements being formed between the first mesa and the second mesa, the plurality of fourth magnetic field sensing elements being formed on a second side of the first mesa and the second mesa.

11. The sensor of claim 10, wherein:
the plurality of first magnetic field sensing elements includes at least two first magnetic field sensing elements that are diagonally opposed to each other in a topology of the first sensing bridge, and the plurality of second magnetic field sensing elements includes at least two second magnetic field sensing elements that are diagonally opposed to each other in the topology of the first sensing bridge; and
the plurality of third magnetic field sensing elements includes at least two third magnetic field sensing elements that are diagonally opposed to each other in a topology of the second sensing bridge, and the plurality of fourth magnetic field sensing elements includes at least two fourth magnetic field sensing elements that are diagonally opposed to each other in the topology of the second sensing bridge.

12. The sensor of claim 10, wherein:
the plurality of first magnetic field sensing elements is positioned off-center from a first portion of the first magnet that is situated between the first mesa and a first edge of the cavity; and
the plurality of fourth magnetic field sensing elements is positioned off-center from a second portion of the first magnet that is situated between the second mesa and a first edge of the cavity.

13. The sensor of claim 10, wherein:
the plurality of second magnetic field sensing elements is positioned in greater proximity to the first mesa than the second mesa; and
the plurality of fourth magnetic field sensing elements is positioned in greater proximity to the second mesa than the first mesa.

14. The sensor of claim 10, wherein the first sensing bridge is configured to sense a magnetic field of the first magnet as the magnetic field is modulated by a rotating target and generate a first sensing signal in response to the magnetic field and the second sensing bridge is configured to sense the magnetic field and generate a second sensing signal, the sensor further comprising electronic circuitry that is configured to generate, based on the first sensing signal and the second sensing signal, an output signal that is indicative of one of speed or direction of movement of the target.

15. The sensor of claim 2, wherein a top surface of the first magnet is flush with or situated lower than a first top surface of the first mesa and a second top surface of the second mesa.

16. The sensor of claim 2, wherein the first magnet is arranged to cover a first top surface of the first mesa and a second top surface of the second mesa.

17. The sensor of claim 1 or 2, wherein the cavity is defined by a plurality of edges and the first magnet is arranged to cover respective top surfaces of the plurality of edges.

18. The sensor of claim 1 or 2, wherein the cavity is defined by a plurality of edges, the sensor further comprising a second magnet that is disposed over the first magnet, the second magnet being arranged to cover respective top surfaces of the plurality of edges.

19. A sensor comprising:
a substrate having a cavity formed in a first main surface of the substrate;
a first magnet that is formed in the cavity, the first magnet being arranged to at least partially fill the cavity;
a first sensing bridge that is formed on a second main surface of the substrate, the second main surface being opposite to the first main surface, the first sensing bridge being arranged sense a magnetic field of the first magnet as the magnetic field is modulated by a rotating target and generate a sensing signal in response to the magnetic field.

20. The sensor of claim 19, further comprising:
a second sensing bridge that is formed on the second main surface of the substrate; and
an electronic circuitry that is configured to generate a signal that is indicative of speed or direction of the rotating target based on at least one of a first output of the first sensing bridge and a second output of the second sensing bridge.

21. The sensor of claim 19, further comprising, a mesa that extends from a bottom of the cavity, wherein the magnet is configured to surround the mesa.

22. The sensor of claim 19, further comprising a second magnet that is disposed over the first magnet.

23. The sensor of claim 19, further comprising a second magnet that is disposed over the first magnet and configured to cover one or more edges of the substrate that define the cavity.

24. The sensor of claim 19, further comprising:
a first mesa that extends from a bottom of the cavity;
a second mesa that extends from the bottom of the cavity,
wherein the magnet is configured to surround the first mesa and the second mesa.

25. The sensor of claim 19, wherein the first sensing bridge includes:
a plurality of first magnetic field sensing elements that are disposed underneath a first portion of the first magnet that is situated on a first side of both the first mesa and the second mesa;
a plurality of second magnetic field sensing elements that are disposed underneath a second portion of the first magnet that is situated between the first mesa and the second mesa.

26. The sensor of claim 25, further comprising a second sensing bridge that is formed on the second main surface, wherein:
the second sensing bridge includes: a plurality of third magnetic field sensing elements that are disposed underneath the second portion of the first magnet, and a plurality of fourth magnetic field sensing elements that are disposed underneath a third portion of the first magnet that is situated on a second side of both the first mesa and the second mesa.

27. The sensor of claim 19, wherein the first sensing bridge includes a plurality of tunneling magnetoresistance (TMR) vortex elements.

28. The sensor of claim 1, wherein the first mesa extends from a bottom of the cavity;
wherein the first magnet is ring-shaped; and
wherein the sensor further comprises one or more Hall elements that are formed on a second main surface of the substrate, the second main surface being opposite to the first main surface, the one or more Hall elements being arranged to sense a magnetic field of the first magnet as the magnetic field is modulated by a rotating target and generate a sensing signal in response to the magnetic field.

29. The sensor of claim 19 or 28, further comprising electronic circuitry, that is configured to generate, based at least in part on the sensing signal, an output signal that is indicative of a speed or direction of the rotating target.
